(19) Europäisches Patentamt

European Patent Office

Office européen des brevets

(11) **EP 0 505 333 B1**

(12) **EUROPEAN PATENT SPECIFICATION**

(45) Date of publication and mention
of the grant of the patent:
**23.12.1998 Bulletin 1998/52**

(51) Int Cl.$^6$: **G01R 31/36**

(21) Application number: **92830128.2**

(22) Date of filing: **18.03.1992**

(54) **Estimating the charge of batteries**

Schätzung der Ladung von Batterien

Estimation de la charge de batteries

(84) Designated Contracting States:
**AT BE CH DE DK ES FR GB GR LI LU MC NL PT SE**

(30) Priority: **18.03.1991 IT RM910176**

(43) Date of publication of application:
**23.09.1992 Bulletin 1992/39**

(73) Proprietor: **Ente per le nuove tecnologie, l'energia e l'ambiente ( ENEA)**
**I-00198 Roma (IT)**

(72) Inventors:
- **Zini, Giancarlo**
  **I-56125 Pisa (IT)**
- **Giglioli, Romano**
  **I-56017 S. Giuliano Terme (Pisa) (IT)**
- **Conte, Mario**
  **I-80070 Barano d'Ischia (Napoli) (IT)**

(74) Representative: **Sarpi, Maurizio**
**Studio FERRARIO**
**Via Collina, 36**
**00187 Roma (IT)**

(56) References cited:
**WO-A-89/01169**      **WO-A-90/02432**
**DE-A- 3 429 145**    **US-A- 4 289 836**
**US-A- 4 390 841**    **US-A- 4 455 523**
**US-A- 4 947 123**

## Description

The present invention relates to an electronic apparatus for estimating the charge of lead storage batteries based upon the direct measurement of some parameters and the use thereof in a suitably arranged mathematical model. The invention relates also to a method of estimating the charge of storage batteries.

The invention is aiming at providing an apparatus and a method of the above mentioned kind which is adapted to improve the control of electrochemical storage battery systems in all major applications, and in particular the electrical drive systems, electrical networks (load balancing) and photovoltaic and aeolian systems.

Performance, cost and reliability of electrical vehicles, photovoltaic and aeolian systems, and in general storage battery systems depend upon the capability of controlling the electrical storage batteries.

An accurate estimate of the battery charge can allow a more economical and effective use of the battery capacity and provide for a clear indication about the battery employment and recharge.

A lot of battery charge indicators have been proposed and manufactured especially for lead batteries which are the most used. The variety of such designed devices is also the result of the difficulty of exactly estimating the battery charge of an electrochemical storage battery due to the influence of several parameters such as discharge conditions, temperature, ageing, contechnology, and so on.

At the present state of art the conventional methods are based upon measurements or calculations of the electrolyte density, open-circuit voltage, internal resistance, refractive index, relative humidity of the electrolyte, delivered charge (amperometric method), charging voltage and derivative of the voltage. Tipically, the precision of such known devices seldom is lower than 10% and the use thereof is complex and has a restricted application.

The measurement of the density and the refractive index of the electrolyte can be carried out only for free-acid lead batteries and are complex and dangerous because they sometimes need intrusive sensors as well as balance conditions not suitable for real time estimates; moreover such methods do not allow for the variations due to the ageing of the storage battery. Similar limits can be found in the measurement of internal resistance and open-circuit voltage.

The amperometric method, the measurement of the charging voltage and the derivative of the voltage are greatly restricted by the discharge conditions so that they are inaccurate in those applications where the variation of the discharge current is considerable. Also such methods hardly fits for the ageing of the storage battery.

In order to overcome such problems battery charge indicators have been provided for some time which make use of analog circuits and calculate the battery charge on the basis of complex correlations among main parameters through linear and differential equations.

The used methods are essentially of two types: algebraic and dynamic. Algebraic methods are rather inaccurate while the dynamic method integrating the measured battery current requires a periodic zero setting of the estimated battery charge in order to avoid long range errors; moreover the estimated battery charge is very sensitive to the errors in the current measurements.

A charge indicator suitable for cyclic operation has been described in US Patent 4,390,841. A battery mathematical model forms the basis for making a capacity prediction from measurements of the discharge current and stored battery parameters. Self calibration to take into account of changing battery characteristics due to ageing and charge/discharge history is effected by comparing predicted battery voltage with actual battery voltage and correcting the mathematical model accordingly.

From WO 89/01169 it is known an improved mathematical model which takes into account of the secondary branch current within the battery. However the secondary branch current is calculated "off line" and then subtracted from the current at the battery pole terminal.

The present invention carries out the estimate of the battery charge by means of a more sophisticated dynamic method which does not need any zero setting, is less sensitive to the errors in the current measurements, and considers all the representatives phenomena of the battery behaviour.

The apparatus of the invention is based upon a mathematical model simulating an equivalent network of a lead acid battery during the charging, discharging and gassification steps. By only directly measuring battery current and voltage and room temperature the apparatus allows the battery charge to be exactly measured and offers the possibility of performing a control function.

A peculiar feature of the apparatus is that the storage battery is on-line arranged and the mathematical model fits the real state of the storage battery even during the operating life thereof, assuming that the secondary branch current is function of the dynamic behaviour of the battery system.

Such apparatus of the "autoadaptive" type also permits all operating conditions to be corrected and controlled at any time during the operating life of the storage battery, thus holding the precision of the charge measurement steady also by virtue of suitable error correction sequences regarding one or more significant quantities (voltage, temperature, current).

The invention will now be described with reference to the accompanying drawings showing by way of an illustrative, non-limitative example a preferred embodiment of the invention.

In the drawings:

Fig. 1 is a block diagram of the operating principle of the storage battery charge estimating apparatus according the the invention;

Fig. 2 shows the equivalent electrical diagram of a lead storage battery according to the employed model;

Fig. 3 is the complete block diagram of the battery charge estimating apparatus showing both the measured and the estimated quantities in the process;

Fig. 4 is a block diagram of an embodiment of the apparatus;

Fig. 5 shows the flow diagram of the mathematical model for the battery parameters and charge estimate;

Fig. 6 shows the application of the apparatus to a photovoltaic system; and

Fig. 7 is the flow diagram of the operation of the calculation and control unit of Fig. 6.

The apparatus according to the invention essentially includes:

a) transducers for measuring battery current and voltage and the temperature of the room where the storage battery is placed;

b) a conditioning and analog-to-digital conversion system for the signals of said sensors;

c) a microprocessor system processing the signals of a) and b) by the computer program of the following item e);

d) a power supply for systems b) and c) formed of a power conditioner supplied in turn by the storage battery; and

e) a program for processing data signals of items a) and b) which can provide:

1.- estimate of the storage battery charge and the internal temperature of the storage battery;

2.- estimate of the storage battery "life" condition;

3.- estimate of the electrolyte level in those storage batteries where the electrolyte is consumed due to secondary (parasitic) reactions;

4.- signal information for controlling the power supply of d) above;

5.- signal information for controlling any power conditioners such as battery chargers, controlled rectifiers, choppers, inverters and so on;

6.- signal information about any failed element of the storage battery.

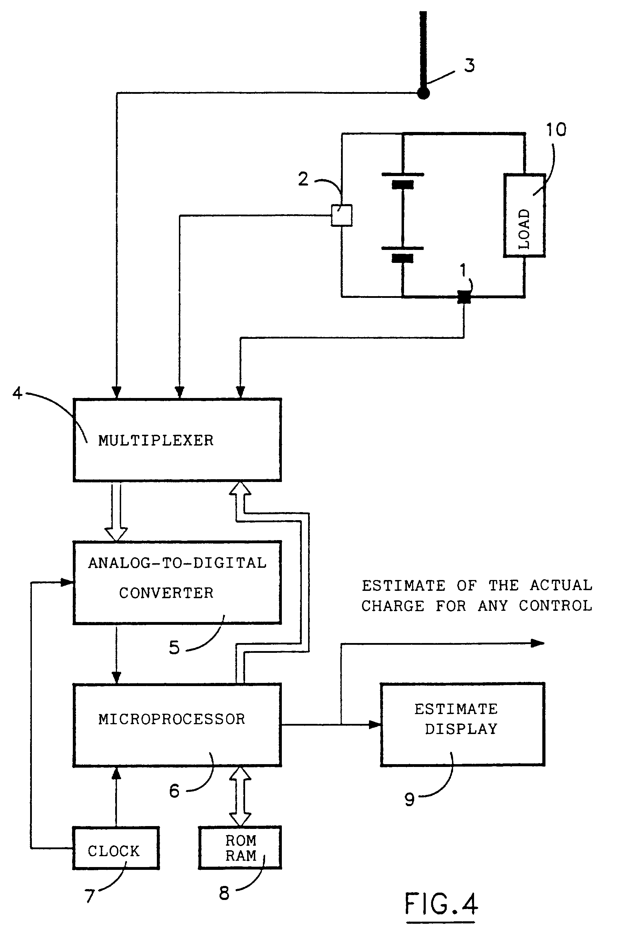

A preferred embodiment of the above mentioned apparatus is schematically shown in Fig. 4. In such figure battery current sensors, battery voltage sensors and room temperature sensors are designated by 1, 2 and 3, respectively. A multiplexer connected upstream of analog-to-digital converter 5 of the measured quantities is designated by 4. Such quantities are fed to microprocessor 6 which processes the signals on the basis of the estimate program stored in RAMs and ROMs 8 and transmits the estimated values to a digital display 9 and/or to an output 10 available for control devices. System clock is indicated at 7.

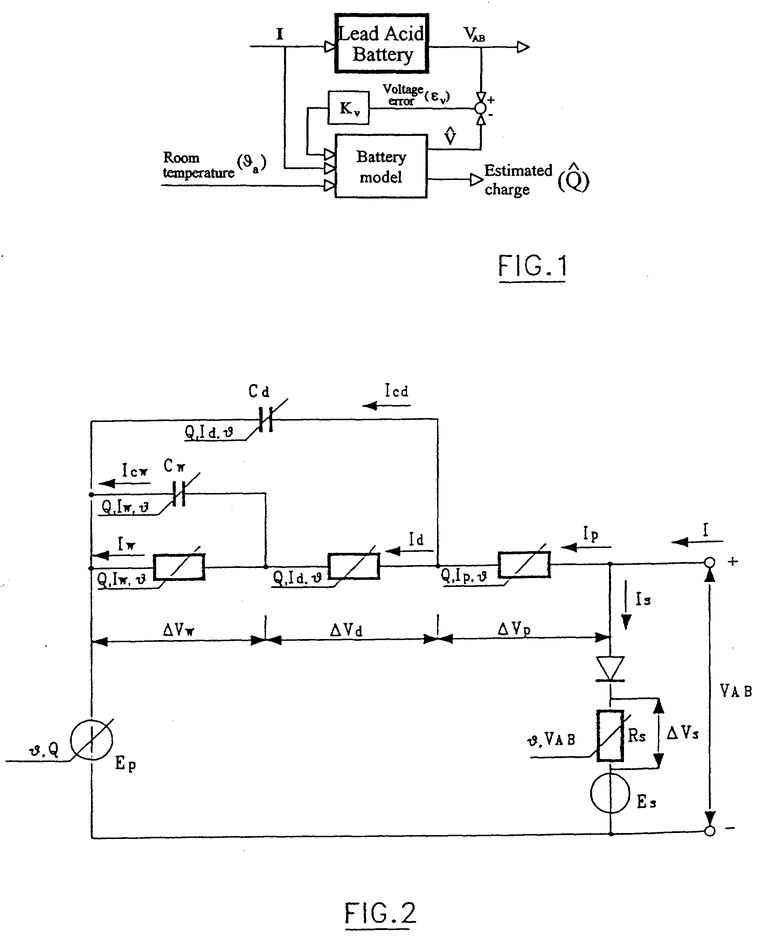

The battery charge estimate apparatus has been developed on the basis of the battery model shown in the equivalent electricl diagram of Fig. 2.

The equivalent electrical network consists of two main branches:

- a primary branch (P) representing the main reversible oxidation-reduction reaction during the charging-discharging steps;

- a secondary branch (S) representing the irreversible parasitic reactions (the most important is the water electrolysis) causing the losses during the charging step.

The components of Fig. 2 are designed considering the influence of the temperature and the age of the battery. Furthermore the thermal balance does not allow for the thermodynamic contribution of the reactions during the charging and discharging steps which is much lower than the Joule effect losses.

As the storage battery is an electrical dipole, it can be transformed into a non-linear dynamic system model having a current as input signal and a voltage as output signal.

The state variables of such system can be selected as follows:

Q (Ah): extracted electrical charge (which is the charge necessary to completely recharge the battery);

$\delta\theta$ (°C): difference between electrolyte and room temperatures;

Id(A) and Iw(A) : "charge transfer" current and "diffusion" current, respectively.

With reference to such state variables and the network shown in Fig. 2 the battery model can be espressed by the following equations:

| Dynamic equations | Algebraic equations |
|---|---|
| $\frac{dI_d}{dt} = \frac{1}{t_d}(I_p\text{-}I_d)$ | $V_{AB}\text{-}R_pI_p\text{-}R_wI_w\text{-}E_p=0$ |
| $\frac{dI_w}{dt} = \frac{1}{t_w}(I_d\text{-}I_w)$ | $I_s\text{-}G_sV_{AB}=0$ |
| | $I\text{-}I_p\text{-}I_s=0$ |
| $\frac{d\delta\vartheta}{dt} = \frac{1}{t}(P_lR_\vartheta\text{-}\delta\vartheta)$ | $P_l\text{-}R_pI_p^2\text{-}R_dI_d^2\text{-}R_wI_w^2\text{-}(V_{AB}\text{-}E_s)I_s=0$ |
| $\frac{dQ}{dt} = \text{-}I_p$ | $\vartheta\text{-}\vartheta_a\text{-}\delta\vartheta=0$ |

TABLE 1

| Variable symbol | Variable name | Units of measurement |
|---|---|---|
| I | battery current | A |
| $I_d$ | charge transfer current | A |
| $I_w$ | diffusion current | A |
| $I_p$ | primary branch current | A |
| $I_s$ | secondary branch current | A |
| $R_d$ | charge transfer resistance | $\Omega$ |
| $R_w$ | diffusion resistance | $\Omega$ |
| $R_p$ | polarisation resistance | $\Omega$ |
| $G_s$ | gassing admittance | S |
| $t_d$ | charge transfer time constant | s |
| $t_w$ | diffusion time constant | s |
| $\vartheta$ | electrolyte temperature | °C |
| $\vartheta_a$ | room temperature | °C |
| Q | estimated charge | Ah |
| $P_l$ | power lost | W |
| $V_{AB}$ | battery terminal voltage | V |
| $E_s$ | gassing electromotive force | V |

The operation of the storage battery charge estimate apparatus according to the invention is schematically shown in Fig. 1.

The dynamic model of the storage battery is activated by the battery input current and requires only the measurements of battery voltage and room temperature. With a perfect model and appropriate initial values of the battery charge there is no error in the charge estimate. However, the unavoidable errors in the model and in the initial charge values will cause an unforeseenable error in the estimated charge Q.

In order to limit such errors the dynamic behavioral model is corrected according to the invention by the negative feedback of the differential error between the measured voltage and the estimated voltage. The error amount is due to a wrong value of the initial charge causing an error in the output voltage of the model, the model parameters being estimated by a separate process. Therefore, the voltage error is used for modifying directly the derivative of the model's charge. In this way the estimated charge converges asymptotically to the value which cause the voltage error to tend to zero.

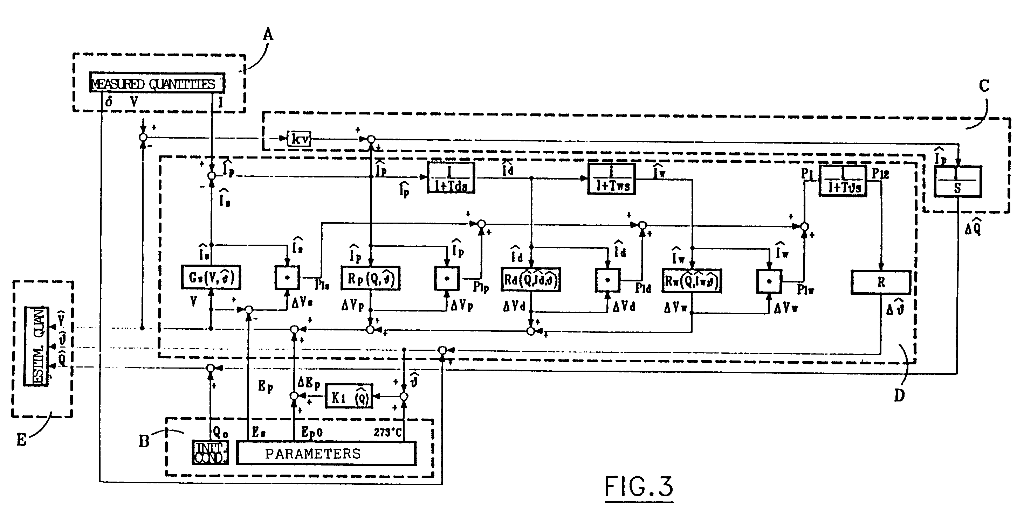

Fig. 3 shows the complete block diagram of the battery charge estimate apparatus where both the measured quantities and the estimated quantities in the process are emphasized. The dashed blocks represent respectively:

block A: measurement and analog-to-digital system;

block B: off-line battery parameter measurement system;
block C: battery charge estimate system allowing for voltage error;
block D: integration of the dynamic equations allowing for the capacities of the battery model and the thermal equation;
block E: output of the estimated quantities; where:

$T_d$ = fast time constant of the electrical dynamics of the battery;
$T_w$ = slow time constant of the electrical dynamics of the battery;
$T$ = thermal time constant;
$G_s$ ($V_{AB}$, $\theta$) is the conductance of the passive branch;
$R_p$ ($Q$, $\theta$) is the ohmic resistance of the active branch;
$R_d$($Q$, $I_d$, $\theta$) is the diffusion resistence;
$R_w$ ($Q$, $I_w$, $\theta$) is the polarization resistance.

In particular, the equation of the extracted charge variation is:

$$\frac{d\hat{Q}}{dt} = -\hat{I}_p + K_v (\hat{V}_{AB} - V_{AB})$$

where the quantities overlain by the sign $\wedge$ are estimated by means of the battery model and $K_v$ is the gain of the voltage error. If the voltages are expressed in volts (V) and the currents are expressed in amperes (A), $k_v$ is obviously expressed in A/v. As for the error reaction the following considerations have to be pointed out:

1) the measurement of the battery voltage is the only simple measurement allowing an error reaction; it is carried out an adjustment of the battery charge derivative because it is not available any information about errors regarding other quantities. In order to improve the accuracy of the battery charge estimate apparatus further measurements should be carried out: for example, a second error reaction can be actuated by a measurement of the electrolyte temperature. Of course, the more information is available, the greater is the accuracy of the estimated values.
2) as for the selection of the error gain a compromise between the accuracy of the apparatus and the response rate thereof should be accepted; the greater is the gain, the higher is the response rate but also the bigger is the error in the estimated values.

By way of example an experimentally tested operation of the apparatus according to a feasible arrangement with TTL technology will now be explained with regard to measurement and control functions in a photovoltaic system based upon the equivalent electrical diagram of Fig. 2.

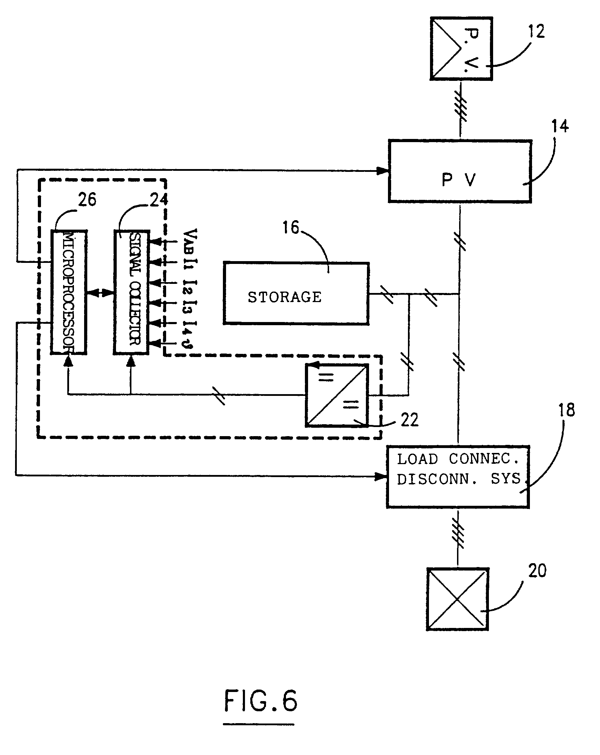

The diagram of a photovoltaic system with storage batteries is shown in Fig. 6 where the photovoltaic panels are indicated at 12, the panel connection and disconnection system at 14, the storage batteries at 16, the load connection and disconnection system at 18, and the load at 20.

The apparatus according to the invention is schematically formed by the components contained in the blocks surrounded by dashed lines. Said apparatus includes:

- a power supply unit 22 (ac/dc converter connected to the storage battery);
- a data collection unit 24 detecting by not particularly sophisticated sensors currents, voltages and temperatures (six quantities as a whole);
- a data processing and control unit (micro-processor) 26 which is adapted to control both the electric energy (in this case it chokes the output of the photovoltaic field by controlling choppers and relays) and the user by connecting and disconnecting several loads according to different priorities.

In the operation the apparatus continuously measures the electrical characteristics of the storage batteries, voltage and current, and room temperature. The other three current values in the branch point (load current, photovoltaic current, and insolation) allow the diagnostic about the correct operation of the data collection system to be provided.

Data collection unit 24 is the interface between the outer sensors placed on the photovoltaic system and processing unit 26. All of measurement channels have a precision amplifier and a linear optical decoupler connected to an A/D converter. The amplifier allows the input signal. to be calibrated and adapted to the conversion range of the control system.

The earthing elements of the control system and those of the whole system are galvanically separated by an optical decoupling device in order to prevent any disturbance.

Calculation and control unit 26 based upon a microprocessor system compatible with MS-DOS environment (in this example a microprocessor INTEL 8088 with clock at 4,77 MHz and 512 kB memory is used) performs the function of controlling the whole system based upon the determined quantities, thus always supplying the load with the prefixed power, using the maximum power delivered by the photovoltaic generator, and never causing the battery to discharge under a predetermined level so as not to reduce the useful life thereof.

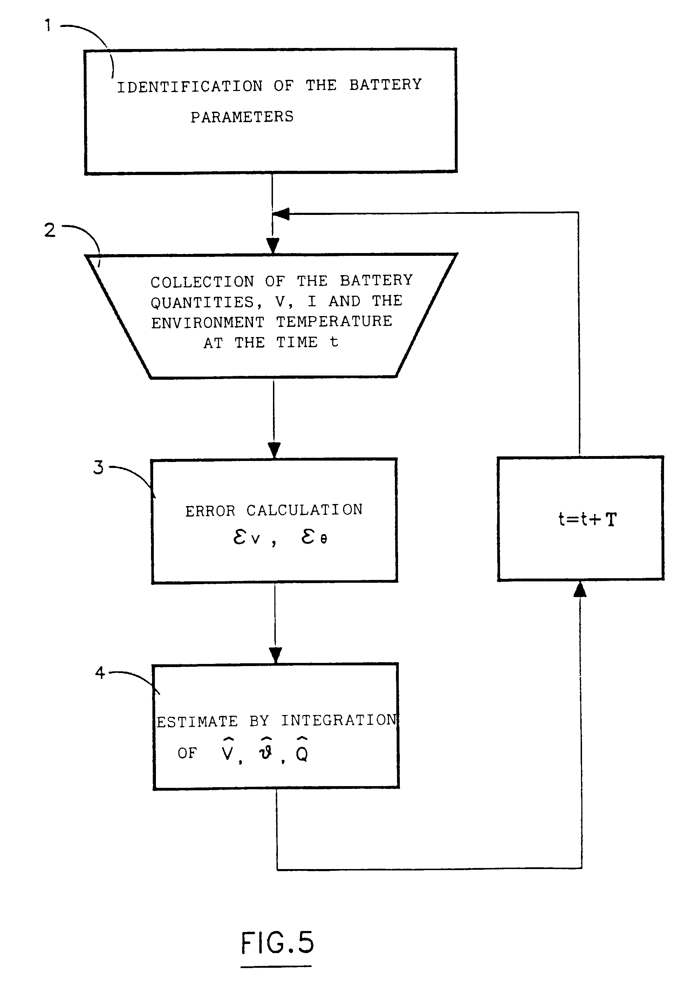

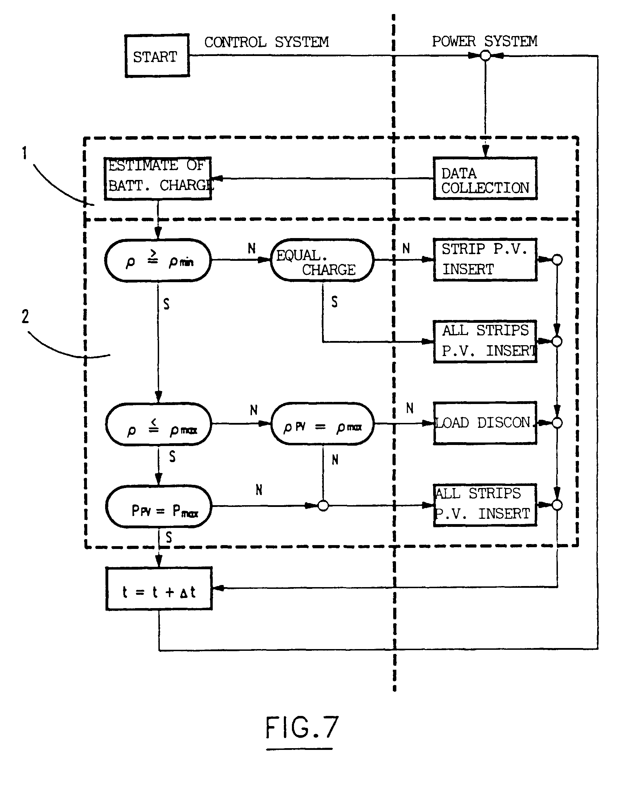

In the operation of the system the apparatus according to the invention operates on the basis of the block diagram of Fig. 7. In such figure, block 1 delimited by dashed lines corresponds to the battery charge estimate apparatus, and block 2 to the control logic of the photovoltaic system; $\rho$ is the discharge rating of the battery, $\rho_{min}$ and $\rho_{max}$ are the limits of the discharge rating; strip PV indicates a connectable or disconnectable photovoltaic panel, $P_{PV}$ is the power generated by the photovoltaic system. After having initialized the input parameters of the storage battery model the apparatus starts the readout of the storage battery model as well as the relative quantities and converts the system measurement values by the A/D converter. Data is fed into the computer program relative to the battery charge and the other parameters of the lead storage battery. The estimate of the storage battery charge is carried out by integrating differential equations as shown in the flow diagram of Fig. 5. Referring to such diagram it should be noted that the identification of the battery parameters, which is the first step, is carried out off-line by dynamic and discharge tests before starting the system. The parameters can be calculated again during the maintenance periods of the system in which the estimate apparatus is connected.

Second step: quantities V, I measured at the battery terminals, and room temperature are sampled with a sampling time T sufficient for the microprocessor to carry out the estimate.

Third step: calculation of the error between measured voltage V and estimated voltage $\hat{V}$. If a measurement of the electrolyte temperature is available, also the error between measured electrolyte temperature O and estimated electrolyte temperature $\hat{O}$ can be calculated.

Fourth step: integration of the model equations by introducing a corrective factor depending on the previously calculated error. Such corrective factor increases or decreases current $I_p$ flowing along the active branch of the battery model. Quantities $\hat{V}$, $\hat{O}$, $\hat{Q}$ at time $t + T$ are thus estimated.

Fifth step: measurement and calculation cycle is started again at time $t = t + T$.

Once the storage battery charge is estimated on the basis of intially predetermined conditions relative to the minimum and the maximum charge, to the priority of the several loads, and to the optimum working point of the various subsystems, the apparatus of the present invention operates so as to disconnect the loads, to choke the power supply, and under limit conditions (too much discharged battery) to break the power supply.

In this specific case the use of the storage batteries as well as the whole efficiency of the system have been improved, and a battery charge estimate error of about 3% has been provided, which could not be achieved by the known systems.

As mentioned above, this invention can be used both in moving and stationary applications where lead storage batteries are employed. It can be particularly useful in the electrical traction, in systems with power sources which can be restored, and in electrical network load equalizing; in fact the invention allows the design, the management, and the use of the storage battery subsystem and the whole system to be optimized with considerable energetic, economical advantages.

The present invention has been illustrated and described according to a preferred embodiment thereof, however it should be appreciated that construction modifications can be made by those skilled in the art without departing from the scope of the present industrial invention.

## Claims

1. A method of estimating the charge of electrochemical lead-acid storage batteries comprising the steps of:

   - introducing the measured voltage, the current, the room temperature where the battery is installed, and the estimated electrolyte temperature as function of said room temperature in a dynamic model of the battery utilizing a system of four differential interconnected equations to be integrated, said model being represented by an equivalent electric network in order to simulate the steps of charging and/or discharging and gasification;
   - correcting the dynamics of the model by the negative feedback of the differential error signal between the voltage measured and the estimated voltage obtained from the simulation on real time;
   - directly modifying the derivative of the charge of the model according to the equation:

$$\frac{d\hat{Q}}{dt} = -\hat{I}_p + K_v(\hat{V}_{AB} - V_{AB})$$

where the quantities overmarked by the sign ^ are estimated by means of the battery model, $I_p$ is the current

flowing along the primary branch of two branches of the model and $K_v$ is the gain of the differential voltage signal.

2. The method of estimating the charge of electrochemical storage batteries as claimed in claim 1 characterized in that the input parameters of the storage battery model are initialized on the basis of the measured parameters of the tested storage battery.

3. The method of estimating the charge of electrochemical storage batteries as claimed in the preceding claims characterized in that the measurement of the electrolyte temperature is also provided.

4. The method of estimating the charge of electrochemical storage batteries as claimed in the preceding claims characterized in that the values of the direct measurements of battery voltage and current and room temperature, and if it is the case also the electrolyte temperature, are converted by an analog-to-digital converter.

5. The method of estimating the charge of electrochemical storage batteries as claimed in the preceding claims characterized in that the processing of the converted data is carried out in a microprocessor system by a software adapted to provide the estimate of the storage battery charge, the internal temperature of the storage battery, the "life" conditions thereof, the electrolyte level for those storage batteries where the electrolyte is consumed due to secondary reactions, signal information for any control and signal information about any failure.

6. An apparatus for estimating the charge of electrochemical lead-acid storage batteries measuring the battery voltage and current, and the room temperature where the storage battery is installed, characterized in that it includes a microprocessor (6) which uses the method of estimating the storage battery charge according to any of claims 1 to 5.

7. The apparatus as claimed in claim 6, characterized in that a conditioning and A/D conversion system (5) for the signals from transducers (1, 2, 3) is connected between said microprocessor (6) and said transducers (1, 2, 3).

8. The apparatus as claimed in claims 6 to 7, characterized in that the microprocessor and the conditioning system are supplied by a power conditioner supplied in turn by the storage battery.

9. The apparatus as claimed in claims 6 to 8 characterized in that the microprocessor is adapted to provide a sequence of informations relative to the operating data of the storage battery besides providing the estimate of the storage battery charge in real time.

10. The apparatus as claimed in claims 6 to 9 characterized in that said information and/or signals include the internal temperature, the "life" conditions of the storage battery, and the electrolyte level besides the information for controlling the power supply and any power conditioner, and for signalling any failure.

11. The apparatus as claimed in claim 6 to 10 characterized in that said processing and calculation system operates so as to disconnect the loads, to choke the power supply and, in case of too much discharged battery, to break the power supply on the basis of initially predetermined conditions relative to the minimum and the maximum battery charge, the priority of the several loads, and the optimum working point of the various sub systems.


**Patentansprüche**

1. Verfahren zur Bestimmung des Ladezustandes von elektrochemischen Säure-Speicherbatterien, wobei das Verfahren die folgende Schritte aufweist:

Einführen der gemessenen Spannung, des Stromes, der Raumtemperatur, bei welcher die Batterie installiert ist,
sowie der geschätzten Elektrolyttemperatur als Funktion der Raumtemperatur in einem dynamischen Modell der Batterie unter Verwendung eines Systems, das aus vier miteinander verbundenen zu integrierenden Differentialgleichungen besteht, wobei das Modell durch eine elektrische Ersatzschaltung zur Simulation des Ladens und/oder des Entladens und der Gasbildung dargestellt wird,
Korrigieren der Modelldynamik durch die negative Rückkopplung des differentiellen Fehlersignals zwischen der gemessenen Spannung und der geschätzten Spannung, die aus der Simulation in Echtzeit erhalten wird, direktes Verändern der Ableitung der Ladung des Modells entsprechend der Gleichung:

$$\frac{d\hat{Q}}{dt} = -\hat{I}_p + K_v(\hat{V}_{AB} - V_{AB})$$

wobei die Größen, welche das Zeichen ^ aufweisen, mittels des Batteriemodels geschätzt werden, $I_p$ der Strom ist, welcher entlang des Hauptzweiges der beiden Zweige des Modelles fließt, und $K_v$ die Verstärkung des Differenzspannungssignals ist.

2. Verfahren zur Bestimmung des Ladezustandes von elektrochemischen Speicherbatterien nach Anspruch 1, **dadurch gekennzeichnet,**

daß die Eingangsparameter des Speicherbatteriemodells auf der Grundlage der gemessenen Parameter der getesteten Speicherbatterie initialisiert werden.

3. Verfahren zur Bestimmung des Ladezustandes von elektrochemischen Speicherbatterien nach einem der vorangehenden Ansprüche,
**dadurch gekennzeichnet,**
daß die Messung der Elektrolyttemperatur ebenfalls vorgesehen ist.

4. Verfahren zur Einschätzung des Ladezustandes von elektrochemischen Speicherbatterien nach einem der vorangehenden Ansprüche,
**dadurch gekennzeichnet,**
daß die Werte der Direktmessungen der Batteriespannung,des Stromes und der Raumtemperatur und gegebenenfalls auch der Elektrolyttemperatur durch einen Analog-Digital-Wandler konvertiert werden.

5. Verfahren zur Bestimmung des Ladezustandes elektrochemischer Speicherbatterien nach einem der vorangehenden Ansprüche,
**dadurch gekennzeichnet,**
daß die Datenverarbeitung der konvertierten Daten in einem Mikroprozessorsystem durch eine Software erfolgt, die dazu ausgelegt ist den Bestimmungswert der Speicher-Batterieladung, der internen Temperatur der Speicherbatterie, der "Lebens-" bedingungen der Batterie, den Elektrolytpegel für diejenigen Speicherbatterien, bei dem der Elektrolyt aufgrund von Sekundärreaktionen verbraucht wird, und ein informationstragendes Signal für eine beliebige Steuer- und Signalinformation bezüglich eines Versagens zu liefern.

6. Vorrichtung zur Bestimmung des Ladezustandes von elektrochemischen Säure-Speicherbatterien, welcher die Batteriespannung, den Strom und die Raumtemperatur, bei welcher die Speicherbatterie installiert ist, mißt,
**dadurch gekennzeichnet,**
daß sie einen Mikroprozessor (6) enthält, welcher das Verfahren zur Bestimmung des Speicherbatterieladezustandes gemäß einem der Ansprüche 1 bis 5 verwendet.

7. Vorrichtung nach Anspruch 6,
**dadurch gekennzeichnet,**
daß ein Bearbeitung- und A/D-Wandler-System (5) für die von den Meßwertwandlern (1, 2, 3) ausgehenden Signale zwischen dem Mikroprozessor (6) und den Meßwertwandlern (1, 2, 3) angeschlossen ist.

8. Vorrichtung nach einem der Ansprüche 6 bis 7,
**dadurch gekennzeichnet,**
daß der Mikroprozessor und das Bearbeitungssystem bzw. Konditioniersystem durch eine Stromversorgungskonditioniereinrichtung versorgt werden, die ihrerseits durch die Speicherbatterie versorgt wird.

9. Vorrichtung nach einem der Ansprüche 6 bis 8,
**dadurch gekennzeichnet,**
daß der Mikroprozessor neben der Lieferung des Bestimmungswertes der Speicherbatterieladung in Echtzeit dazu ausgelegt ist eine Sequenz von Informationen relativ zu den Betriebsdaten der Speicherbatterie zu liefern.

10. Vorrichtung nach einem der Ansprüche 6 bis 9,
**dadurch gekennzeichnet,**
daß die Information und/oder Signale neben der Information zur Steuerung der Stromversorgung und einer Stromversorgungs-Konditioniereinrichtung und für die Signalisierung eines Versagens die interne Temperatur, die "Lebens-" zustände der Speicherbatterie enthalten.

**11.** Vorrichtung nach einem der Ansprüche 6 bis 10,
**dadurch gekennzeichnet,**
daß das Datenverarbeitungs- und Berechnungssystem derart arbeitet, daß die Lasten abgeschaltet werden, die Stromversorgung gedrosselt wird und im Falle einer zu stark geladenen Batterie auf der Grundlage der anfänglich vorbestimmten Zustände relativ zu der minimalen und maximalen Batterieladung, der Priorität der verschiedenen Lasten und des optimalen Arbeitspunktes der verschiedenen Subsysteme die Stromversorgung unterbrochen wird.

**Revendications**

**1.** Un procédé d'estimation de la charge de batteries d'accumulateurs électrochimiques plomb-acide comprenant les opérations consistant à :

- introduire la tension mesurée, le courant mesuré, la température mesurée de la pièce où est placée la batterie, ainsi que la température estimée de l'électrolyte en fonction de ladite température de la pièce dans un modèle dynamique de la batterie utilisant un système de quatre équations différentielles reliées entre elles pour être intégrées, ledit modèle étant représenté par un réseau électrique équivalent de manière à simuler les opérations de charge et/ou de décharge et de gazéification ;

- corriger les dynamiques du modèle par la rétroaction négative du signal d'erreur différentielle entre la tension mesurée et la tension estimée obtenue d'après la simulation en temps réel ;

- modifier directement la dérivée de la charge du modèle selon l'équation

$$\frac{d\hat{Q}}{dt} = -\hat{I}_p + K_v(\hat{V}_{AB} - V_{AB})$$

où les quantités surmontées du signe ^ sont estimées au moyen du modèle de batterie, $I_p$ est le courant passant le long de la branche primaire parmi deux branches du modèle et $K_v$ est le gain du signal de tension différentielle.

**2.** Le procédé d'estimation de la charge de batteries d'accumulateurs électrochimiques tel que revendiqué à la revendication 1, caractérisé en ce que les paramètres d'entrée du modèle de batterie d'accumulateur sont initialisés sur la base des paramètres mesurés de la batterie d'accumulateur testée.

**3.** Le procédé d'estimation de la charge de batteries d'accumulateurs électrochimiques tel que revendiqué aux revendications précédentes, caractérisé en ce qu'on prévoit également la mesure de la température de l'électrolyte.

**4.** Le procédé d'estimation de la charge de batteries d'accumulateurs électrochimiques tel que revendiqué aux revendications précédentes, caractérisé en ce que les valeurs des mesures directes de la tension et du courant de la batterie ainsi que la température de la pièce et, le cas échéant, également la température de l'électrolyte, sont converties par un convertisseur analogique-numérique.

**5.** Le procédé d'estimation de la charge de batteries d'accumulateurs électrochimiques tel que revendiqué aux revendications précédentes, caractérisé en ce que le traitement des données converties est effectué dans un système à microprocesseur par un logiciel adapté à créer l'estimation de la charge de la batterie d'accumulateur, la température interne de la batterie d'accumulateur, ses conditions de "durée de vie", le niveau de l'électrolyte pour celles des batteries d'accumulateurs où l'électrolyte est consommé du fait de réactions secondaires, des informations de signaux pour une commande quelconque et des informations de signaux concernant un défaut quelconque.

**6.** Un appareil d'estimation de la charge de batteries d'accumulateurs électrochimiques plomb-acide en mesurant la tension et le courant de la batterie, ainsi que la température de la pièce où est placée la batterie d'accumulateur, caractérisé en ce qu'il comprend un microprocesseur (6) qui utilise le procédé d'estimation de la charge de batteries d'accumulateurs selon une quelconque des revendications 1 à 5.

**7.** L'appareil tel que revendiqué à la revendication 6, caractérisé en ce qu'un système (5) de conditionnement et de conversion A/N pour les signaux provenant de transducteurs (1, 2, 3) est relié entre ledit microprocesseur (6) et lesdits transducteurs (1, 2, 3).

8. L'appareil tel que revendiqué aux revendications 6 à 7, caractérisé en ce que le microprocesseur et le système de conditionnement sont alimentés par un conditionneur d'énergie électrique alimenté à son tour par la batterie d'accumulateur.

9. L'appareil tel que revendiqué aux revendications 6 à 8, caractérisé en ce que le microprocesseur est prévu pour créer une séquence d'informations relatives aux données de fonctionnement de la batterie d'accumulateur en plus de créer l'estimation de la charge de la batterie d'accumulateur en temps réel.

10. L'appareil tel que revendiqué aux revendications 6 à 9, caractérisé en ce que lesdites informations et/ou signaux comprennent la température interne, les conditions de "durée de vie" de la batterie d'accumulateur, ainsi que le niveau de l'électrolyte en plus des informations permettant de commander l'alimentation en énergie électrique et tout conditionneur d'énergie électrique et pour signaler un défaut quelconque.

11. L'appareil tel que revendiqué aux revendications 6 à 10, caractérisé en ce que ledit système de traitement et de calcul fonctionne de manière à déconnecter les charges mécaniques, à amortir l'alimentation en énergie électrique et, dans le cas d'une batterie trop déchargée, à rompre l'alimentation en énergie électrique sur la base de conditions initialement prédéterminées relatives à la charge électrique minimum et maximum de la batterie, la priorité de plusieurs charges mécaniques, et le point de travail optimal des divers sous-systèmes.

FIG.1

FIG.2

FIG.3

3

10

2

LOAD

1

4

MULTIPLEXER

ANALOG-TO-DIGITAL
CONVERTER

5

ESTIMATE OF THE ACTUAL
CHARGE FOR ANY CONTROL

MICROPROCESSOR

6

ESTIMATE
DISPLAY

9

CLOCK

7

ROM
RAM

8

FIG.4

1

IDENTIFICATION OF THE BATTERY
PARAMETERS

2

COLLECTION OF THE BATTERY
QUANTITIES, V, I AND THE
ENVIRONMENT TEMPERATURE
AT THE TIME t

3

ERROR CALCULATION
$\mathcal{E}_V$ , $\mathcal{E}_\theta$

4

ESTIMATE BY INTEGRATION
OF $\hat{V}$ , $\hat{\vartheta}$ , $\hat{Q}$

$t = t + T$

FIG.5

FIG.6

FIG.7